# FASCICULE DE BREVET EUROPEEN

(11) **EP 2 105 955 B1**
(45) Date de publication et mention de la délivrance du brevet: **11.05.2011**
(21) Numéro de dépôt: 09155734.8
(22) Date de dépôt: 20.03.2009
(51) Int. Cl.: H01L 21/425, H01L 33/00

(54) **Procédé de préparation de ZnO ou de ZnMgO dope de type P.**
Herstellungsverfahren von dotiertem ZnO oder ZnMgO vom P-Typ
Method for preparing P-doped ZnO or ZnMgO

(30) Priorité: 27.03.2008 FR 0851967
(43) Date de publication de la demande: 30.09.2009
(73) Titulaire: Commissariat à l'Énergie Atomique et aux Énergies Alternatives, 75015 Paris (FR)
(72) Inventeur: Chevalier, Céline, 38130, ECHIROLLES (FR)
(74) Mandataire: Augarde, Eric

(56) Documents cités:
- WO-A-2007/117158
- GB-A- 2 361 480
- JP-A- 2004 207 721
- US-A1- 2007 235 796
- DATABASE WPI Week 200671 Thomson Scientific, London, GB; AN 2006-684325 XP002502835 & KR 2005 106 882 A (MOX TRONIX CO LTD) 11 novembre 2005 (2005-11-11)
- VAITHIANATHAN ET AL: "Doping of As, P and N in laser deposited ZnO films" JOURNAL OF CRYSTAL GROWTH, ELSEVIER, AMSTERDAM, NL, vol. 287, no. 1, 18 janvier 2006 (2006-01-18), pages 85-88, XP005237043 ISSN: 0022-0248

## Description

L'invention concerne un procédé de préparation de ZnO dopé de type p ou de ZnMgO dopé de type p.

### DOMAINE TECHNIQUE

Le domaine technique de l'invention peut de manière générale être défini comme celui de la préparation, fabrications d'oxyde de zinc ZnO ou d'alliage ZnMgO dopé de type p, c'est-à-dire présentant une conductivité de type p, à partir de ZnO ou d'alliage ZnMgO non dopé, c'est-à-dire présentant une conductivité de type n intrinsèque.

L'oxyde de Zinc ZnO est un matériau semiconducteur qui possède de nombreuses applications en optoélectronique, en particulier dans les LEDs pour l'éclairage sous la forme de couches minces 2D et de nanofils.

La préparation d'oxyde de zinc ZnO dopé de type p s'est avérée difficile.

L'implantation d'ions a été utilisée pour préparer de l'oxyde de zinc dopé avec des dopants de type accepteur tels que de l'azote ou du phosphore mais il s'est avéré que la couche implantée ne présentait pas de conductivité de type p.

### ÉTAT DE LA TECHNIQUE ANTÉRIEURE

Peu de travaux existent sur des implantations d'oxygène dans ZnO et aucun ne révèle la possibilité du dopage de type p grâce à une implantation d'oxygène.

En effet, les documents décrivant les résultats obtenus après implantation d'oxygène dans le ZnO concernent essentiellement la caractérisation des défauts créés par l'implantation.

Le document [1] de Chen et *al*. décrit l'implantation d'ions O+ ou B+ dans du ZnO non dopé présentant une conductivité de type n. Après l'implantation les échantillons sont recuits à une température de 200°C à 1000°C pendant une durée de 30 minutes sous azote. Une température de recuit de 900°C à 1000°C est nécessaire pour éliminer les microvides dans les échantillons implantés par des ions B+, tandis qu'une température de 700°C à 800°C suffit pour éliminer les lacunes dans les échantillons implantés par des ions O+.

Aucun résultat de caractérisation électrique démontrant une conductivité de type p n'est fourni dans ce document.

Le document [2] de Chen et *al*. montre par des études par « positron annihilation » ou par « Raman » l'évolution des agrégats de lacunes induits par l'implantation, selon la température de recuit de guérison pour des échantillons de ZnO implantés avec des ions N+, O+, ou Al+ seul ou co-implantés avec des ions O+/N+ ou Al+/N+. Dans les échantillons implantés avec des ions N+ et les échantillons co-implantés avec des ions Al+/N+ les agrégats (« clusters ») de lacunes sont seulement partiellement éliminés par recuit à 800°C, alors qu'ils le sont totalement dans les échantillons implantés avec des ions O+ ou Al+ par recuit à 800°C-900°C. Dans les échantillons co-implantés avec des ions O+/N+, la plupart des agrégats de lacunes sont éliminés à 800°C, lors d'un autre recuit à 1000°C-1100°C, l'azote forme également des complexes stables avec les lacunes générées thermiquement. Il est démontré dans ce document qu'un recuit à 1200°C-1250°C permet de supprimer ces complexes de lacunes formés par l'implantation d'azote mais aucun résultat de caractérisation électrique démontrant une conductivité de type p n'est fourni.

Le document [3] de Zhao et *al*. présente des résultats de caractérisation par photoluminescence d'échantillons de ZnO implantés par de l'oxygène et du Zinc puis recuits dans l'oxygène pendant 10 minutes à 500°C, puis pendant 10 minutes à 700°C, qui révèlent l'existence d'un pic pouvant correspondre à la présence d'un antisite OZn.

Cette hypothèse est d'ailleurs confirmée dans le document [4] de Vijayakumar et *al*. dans lequel est révélée, dans des échantillons de ZnO implantés par des ions oxygène et sans recuit, par absorption optique, la présence de niveaux attribués à des lacunes de Zn (VZn), des antisites OZn et des lacunes d'oxygène (VO).

Les mesures d'effet Hall, effectuées dans ce document [4] montrent aussi une augmentation importante de la résistivité des couches implantées et une augmentation de la concentration de porteurs.

Le document [5] décrit un procédé pour fabriquer une couche de ZnO enterrée semi-isolante coimplantée par des ions oxygène et azote, pour des « MESFET »

Des ions oxygène et azote sont implantés ensemble, simultanément en quantités égales dans une couche de surface d'oxyde de zinc et on soumet cette couche à un traitement thermique à 800°C.

La résistivité carrée mesurée par effet Hall de la couche semi-isolante formée par la co-implantation suivie du recuit est donnée à 10⁷ Ω/□.

Le document KR-A-2005 106 882 décrit, selon l'abrégé en anglais de ce document, la préparation d'une couche mince de ZnO sur un substrat. Ensuite, des ions dopants de type p tels que des ions As⁺, P⁺, N⁺, Sb⁺, et Bi⁺ sont implantés dans cette couche mince de ZnO à l'aide d'un appareil d'implantation d'ions.

Un traitement thermique rapide (« RTA ») est ensuite réalisé sur la couche mince de ZnO dans laquelle sont implantés les ions dopants.

Il semblerait que, selon là figure 8 de ce document une DEL soit préparée avec une couche de ZnO de type n 210, et une couche active optionnelle comprenant par exemple un « MQW ». Du magnésium peut être ajouté lors de la formation de cette couche active, puis de l'azote est implanté, et un recuit « RTA » a lieu, pour former une couché dopée p, 230. Finalement, des contacts métalliques 240 et 250 sont formés.

Le procédé de ce document ne comporte pas la succession spécifique de deux étapes d'implantation (la première avec des ions O⁺) et de deux étapes de recuit revendiquée.

Le document WO-A-2007/117158 décrit un procédé pour préparer de l'oxyde de Zinc de type p, dans lequel on dope un substrat en ZnO de type n en implantant des ions accepteurs de faible énergie tels que des ions azote, arsenic et phosphore (l'oxygène n'est pas cité) dans le substrat ; on chauffe dans une enceinte sous une pression inférieure à la pression atmosphérique (par exemple 10⁻⁶ mbar) le substrat implanté avec un faisceau d'électrons jusqu'à une température maximale par exemple de 500°C à 1200°C ; on maintient la température maximale pendant une durée prédéterminée par exemple de quelques minutes, et on diminue la température du substrat.

En tant que substrat, on peut utiliser des cristaux d'oxyde de zinc de type n, des couches minces, ou bien encore des substrats massifs, et le procédé de ce document permet alors de préparer du ZnO avec une jonction p-n.

Le procédé de ce document ne comprend qu'une seule étape d'implantation par exemple par des ions N⁺ suivie d'une seule étape de recuit et est donc différent du procédé revendiqué.

Il existe donc, au vu de ce qui précède, un besoin pour un procédé de préparation d'oxyde de zinc ZnO dopé de type p qui présente effectivement un comportement de type p.

Il existe également un besoin pour un procédé de préparation d'oxyde de zinc ZnO dopé de type p qui soit simple et fiable.

### EXPOSÉ DE L'INVENTION

Le but de la présente invention est de fournir un procédé de préparation d'oxyde de zinc ZnO dopé de type p qui réponde entre autres aux besoins mentionnés ci-dessus.

Ce but, et d'autres encore sont atteints, conformément à l'invention par un procédé de préparation de ZnO dopé de type p ou de ZnMgO dopé de type p, dans lequel on réalise les étapes successives suivantes :
a) implantation d'ions oxygène O+ dans un ZnO dopé de type n ou un ZnMgO dopé de type n;
b) premier recuit à une température inférieure ou égale à 1200°C sous oxygène pendant une durée supérieure ou égale à 5 minutes ;
c) implantation d'au moins un ion d'un élément choisi parmi les éléments du groupe I ou les éléments du groupe V du tableau périodique ;
d) second recuit.

Selon l'invention, par ZnO dopé de type n ou ZnMgO dopé de type n, on entend que ce ZnO ou ce ZnMgO présente intrinsèquement une conductivité de type n, c'est-à-dire que ce ZnO ou ce ZnMgO n'a pas été intentionnellement, volontairement dopé de type n mais présente ce dopage, cette conductivité de type n de manière intrinsèque, inhérente.

On désigne également ce ZnO ou ce ZnMgO dopé de type n non intentionnellement, non volontairement par les termes ZnO ou ZnMgO non (intentionnellement) dopé.

Avantageusement, l'implantation d'ions oxygène est réalisée à température ambiante (à savoir généralement 15°C à 30°C, plus précisément 20°C à 25°C, par exemple 22°C ou 23°C) avec une (ou plusieurs) énergie(s) de 100 keV à 300 keV, de préférence de 300 keV, et avec une dose totale minimale de 10¹⁵ cm⁻² pour l'implantation des ions oxygène.

Avantageusement, le premier recuit qui est réalisé à une température inférieure ou égale à 1200°C, pendant une durée supérieure ou égale à 5 minutes, par exemple supérieure ou égale à 15 minutes, peut être réalisé à de 1000°C à 1200°C pendant une durée au moins égale à 5 minutes, par exemple au moins égale à 15 minutes.

Avantageusement, dans l'étape c), on réalise l'implantation d'un ion N, ou P, ou Li.

Avantageusement, l'implantation de l'étape c) est réalisée à température ambiante avec une énergie de 200 keV à 300 keV, de préférence de 250 keV, et avec une dose totale minimale de 10¹⁵ cm⁻² pour l'implantation des ions.

Avantageusement, le second recuit est réalisé à une température de 200°C à 1000°C, de préférence de 400°C à 800°C pendant une durée d'au moins une minute, de préférence de 1 à 60 minutes.

Avantageusement le second recuit est réalisé sous azote, ou sous oxygène ou sous un mélange d'oxygène et d'azote.

Le procédé selon l'invention comporte une suite spécifique d'étapes spécifiques qui n'est ni décrite, ni suggérée dans l'art antérieur tel que représenté notamment par les documents cités plus haut.

Selon l'invention, la préimplantation d'oxygène lors de la première étape, et le recuit intermédiaire lors de la deuxième étape du procédé selon l'invention, permettent une compensation des défauts donneurs intrinsèques au matériau et la création de défauts accepteurs à basse température attestée par un comportement de type p mesuré jusqu'à 150K. Le dopage de type p par impureté extrinsèque est ensuite réalisé par une implantation d'ion d'un élément I ou V, suivi d'un recuit, appelé recuit de guérison et d'activation des dopants.

Le procédé selon l'invention est notamment fondamentalement différent du procédé décrit dans le document [5]. En effet, le procédé du document [5] préconise une co-implantation O⁺ + N⁺ afin de réaliser localement une couche enterrée semi-isolante, alors que dans le procédé selon l'invention, on réalise une préimplantation d'O⁺, suivie d'un recuit approprié permettant de révéler une compensation des donneurs intrinsèquement présents dans le ZnO (ou le ZnMgO) implanté par la mesure effective d'une conduction de type p.

Le procédé de l'invention préconise ensuite une implantation d'un élément accepteur pour ZnO (ou ZnMgO), par exemple : l'azote, le lithium ou le phosphore suivi d'un recuit approprié afin de permettre un dopage de type p du ZnO (ou le ZnMgO) stable jusqu'à la température ambiante par des atomes de type accepteurs extrinsèques.

Le procédé selon l'invention permet la préparation de ZnO dopé de type p ou de ZnMgO dopé de type p, par exemple du ZnO dont le comportement de type p est effectivement prouvé et démontré par les propriétés du matériau obtenu à l'issue de l'étape b) du procédé selon l'invention.

Le ZnO ou le ZnMgO dopé de type p préparé par le procédé selon l'invention peut notamment se présenter sous la forme d'une couche mince 2D, par exemple d'une épaisseur de 500 nm à 1 µm ou de nanofils.

Le ZnO ou le ZnMgO dopé de type n soumis au procédé selon l'invention peut notamment se présenter sous la forme d'un substrat par exemple massif, monolithique, et lorsqu'il est soumis au procédé de l'invention une couche de surface de ce substrat est transformée respectivement en ZnO ou en ZnMgO dopé de type p.

La couche de surface transformée en ZnO ou en ZnMgO dopé de type p de ce substrat, de cette structure, a généralement une épaisseur de 500 nm à 1 µm.

Une telle structure, compacte, monobloc présente des propriétés optiques et électriques modifiées sur une épaisseur comprise entre 500 nm et 1 µm.

Le procédé selon l'invention permet ainsi de créer des accepteurs présentant des propriétés optiques et électriques différentes sur une épaisseur donnée à partir d'un substrat monolithique en ZnO ou en ZnMgO non (intentionnellement) dopé de type n.

On peut ainsi facilement préparer par un procédé simple, et directement à partir d'un simple substrat monolithique une jonction de type p-n sans faire appel par exemple à de multiples étapes de croissance.

Ou bien le ZnO ou le ZnMgO dopé de type n soumis au procédé selon l'invention peut se présenter sous la forme de nanofils.

De manière générale, le ZnO ou le ZnMgO dopé de type p préparé par le procédé selon l'invention peut être utilisé en optoélectronique.

Toutes sortes de dispositifs optoélectroniques peuvent comprendre le ZnO ou le ZnMgO dopé de type p préparé par le procédé selon l'invention ou le substrat, structure en ZnO ou en ZnMgO (non intentionnellement) dopé de type n dont une couche de surface a été respectivement transformée en ZnO ou en ZnMgO dopé de type p par le procédé selon l'invention.

Ce dispositif électronique peut notamment être une diode électroluminescente (DEL ou LED en langue anglaise) en particulier une DEL UV.

### BRÈVE DESCRIPTION DES DESSINS

L'invention sera mieux comprise à la lecture de la description détaillée qui suit donnée à titre illustratif et non limitatif, en référence au dessin joint, dans lequel :

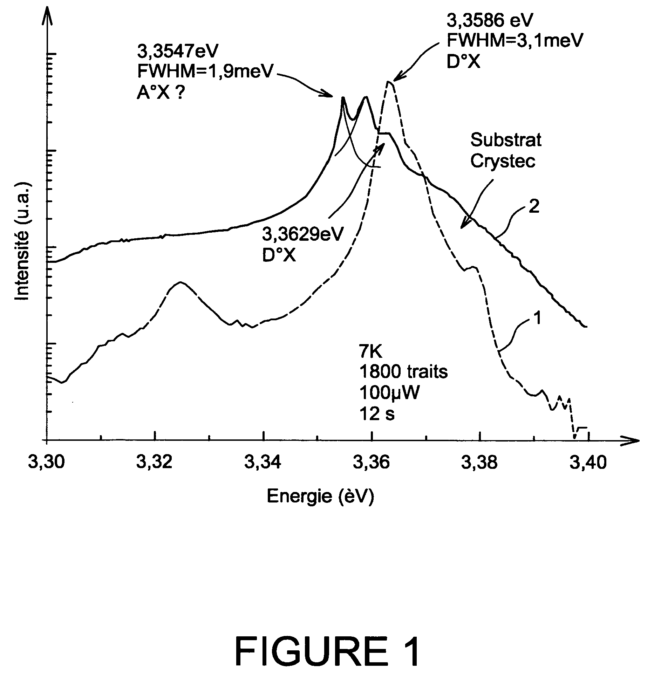

La figure 1 présente le spectre de photoluminescence (① en traits pointillés) réalisé sur un matériau ZnO initialement dopé de type n et le spectre de photoluminescence (② en trait continu) réalisé sur le matériau ZnO préparé dans l'exemple 1.

En abscisse est portée l'intensité (en unités arbitraires u .a.), et en ordonnée est portée l'énergie (eV).

### EXPOSÉ DÉTAILLÉ DE MODES DE RÉALISATION PARTICULIERS

Le procédé selon l'invention comporte une première étape au cours de laquelle on réalise l'implantation d'ions oxygène O+ dans un ZnO ou un ZnMgO initialement dopé de type n, à savoir un ZnO ou un ZnMgO non dopé présentant une conductivité de type n, cette première étape peut également être appelée étape de « préimplantation ».

Le ZnO se présente généralement sous la forme d'un monocristal d'une taille par exemple de 1 cm x 1 cm obtenu par exemple par synthèse hydrothermale.

Dans la première étape du procédé selon l'invention, on réalise l'implantation d'ions oxygène O+ dans le ZnO ou le ZnMgO, non dopé.

L'implantation de la première étape du procédé selon l'invention peut être réalisée avec tout appareil d'implantation d'ions O+.

Cette implantation est généralement réalisée à température ambiante.

Lors de cette étape, les lacunes d'oxygène sont compensées par les atomes d'oxygène incorporés dans la maille par l'implantation. L'implantation doit donc être généralement effectuée avec une dose suffisamment importante pour que les défauts qui sont aussi créés par l'implantation, tels que des lacunes d'oxygène par exemple, soient en concentration inférieure aux atomes d'oxygène implantés.

L'énergie d'implantation est un des paramètres les plus importants pour optimiser au mieux la création des défauts lacunaires dus à l'implantation.

Selon l'invention l'implantation d'ions oxygène est ainsi avantageusement réalisée à température ambiante avec une énergie de 100 keV à 300 keV, de préférence de 300 keV, et avec une dose totale minimale de 10¹⁵ cm⁻² pour l'implantation des ions oxygène.

Une énergie de 300 keV et une dose minimale de 10¹⁵ cm⁻² donnent des résultats satisfaisants.

La deuxième étape du procédé selon l'invention qui suit la première étape d'implantation ou « préimplantation » est une étape de recuit, encore appelé « recuit de guérison », ou « recuit intermédiaire ».

Le recuit de guérison après cette première implantation doit se faire à une température suffisamment élevée et pendant une durée suffisamment longue pour que les impuretés d'oxygène implantées soient activées.

Selon l'invention le recuit de la deuxième étape du procédé ou « recuit de guérison » est effectué à une température inférieure ou égale à 1200°C pendant une durée supérieure ou égale à 5 minutes.

Avantageusement, ce premier recuit est réalisé à une température de 1000°C à 1200°C pendant une durée au moins égale à 5 minutes, par exemple au moins égale à 15 minutes.

La succession de la première étape de préimplantation d'oxygène et de la deuxième étape de recuit intermédiaire permet de compenser, combler, les défauts de type donneur, intrinsèques au matériau, tels que les lacunes d'oxygène, et de créer des défauts accepteurs à basse température.

Le fait que les défauts de type donneur, intrinsèques au matériau, soient comblés est confirmé par les spectres de photoluminescence à basse température, comme le montrent les spectres de photoluminescence de la Figure 1.

L'existence de défauts accepteurs à basse température révèle un comportement de type p, mesuré jusqu'à 150 K comme cela est montré dans l'exemple 1 ci-dessous.

La troisième étape du procédé selon l'invention, suivant la deuxième étape de recuit de guérison après la première étape de préimplantation, consiste en une deuxième implantation permettant un dopage de type p par impureté extrinsèque.

Cette deuxième implantation est une implantation de tout élément de la colonne I ou de la colonne V se substituant à l'oxygène (qui est en concentration normale grâce à la succession de la première et de la deuxième étape précédentes) ou de tout élément de la colonne I se substituant au zinc.

Des ions préférés pour réaliser cette implantation de la troisième étape sont les ions N ou les ions P ou les ions Li.

L'utilisation d'ions azote pour réaliser cette implantation de l'étape c) est réalisée par exemple à température ambiante avec une énergie de 200 keV à 300 keV, de préférence de 250 keV, et avec une dose totale minimale de 10¹⁵ cm⁻²_{.}

A l'issue de la troisième étape du procédé, à savoir de l'étape d'implantation d'au moins un ion d'un élément choisi parmi les éléments du Groupe I et les éléments du groupe V du tableau périodique, il est nécessaire de réaliser une quatrième étape qui est une étape de recuit de guérison et d'activation de l'impureté, du dopant implanté lors de la troisième étape. Cette étape est aussi appelée seconde étape de recuit.

Ce second recuit est généralement réalisé à une température de 200°C à 1000°C, de préférence de 400°C à 800°C pendant une durée d'au moins une minute, de préférence de 1 à 60 minutes.

Généralement, ce second recuit est réalisé sous azote, ou sous oxygène ou sous un mélange d'oxygène et d'azote.

Il est à noter que la température et la durée du second recuit dépendent du type d'ion implanté sous oxygène.

Le procédé selon l'invention permet de préparer du ZnO ou du ZnMgO dopé de type p qui peut être utilisé par exemple sous la forme de couches minces 2D ou de nanofils dans la réalisation de diodes électroluminescentes (DELs) notamment dans l'ultraviolet.

L'invention va maintenant être décrite en relation avec l'exemple suivant, donné à titre illustratif et non limitatif.

### Exemple 1

Dans cet exemple, on a réalisé des spectres de photoluminescence d'un échantillon de ZnO initialement, intrinsèquement dopé de type n et d'un échantillon de ZnO ayant subi les étapes successives a) et b) du procédé selon l'invention.

Les conditions de mesure sont identiques, à savoir une température de 7 K, un réseau de 1800 traits, une puissance laser de 100 µW et une durée d'intégration du spectre de 12 secondes.

Le premier spectre (spectre 1) est obtenu sur un échantillon de ZnO initialement dopé de type n, à savoir un ZnO avant l'étape a).

Cet échantillon de ZnO initialement dopé de type n subit l'étape a) d'implantation d'oxygène du procédé selon l'invention. Les conditions expérimentales de cette implantation sont une énergie de 300 keV avec une dose totale minimale de 10¹⁵ cm⁻².

Une étape de recuit conforme à l'étape b) du procédé selon l'invention est ensuite réalisée à une température de 1200°C pendant une durée de 15 minutes sous oxygène.

Le deuxième spectre (spectre 2) de photoluminescence a été obtenu sur l'échantillon après les étapes a) et b) dans les conditions précitées.

La figure 1 montre ce premier et ce second spectres 1, 2 de photoluminescence.

Le premier spectre 1 présente en particulier un pic situé à 3,36 eV. Il s'agit d'un pic associé à un exciton lié à un donneur. Un tel pic peut être corrélé à la conductivité de type n mesurée sur le substrat.

Ce second spectre 2 montre l'apparition de deux pics situés à 3,3547 eV et 3,3586 eV.

Le pic situé à 3,3629 eV, habituellement associé à un exciton lié au donneur aluminium observé dans tout type de ZnO est fortement diminué après la préimplantation de la première étape et le recuit de la deuxième étape.

Le pic situé à 3,3547 eV est un pic associé à un exciton lié à un accepteur (peut être des oxygènes en interstitiels ou des lacunes de zinc créés par l'implantation).

Nous avons vérifié en effet Hall jusqu'à 150K, un comportement de type p pour un recuit à 1200°C pendant 15 minutes après implantation d'oxygène avec :
- p - 6x10¹³ at/cm² et µ∼0.9 cm²/Vs à 50 K
- p - 6.7x10¹³at/cm² et ∼2 cm²/Vs à 100 k
- p ∼2.4x10¹⁴ at/cm² et µ∼2.1 cm²/Vs à 150 K.

### REFERENCES

[1] Z.Q. CHEN ET AL., " Annealing process of ion-implantation-induced defects in ZnO: Chemical effect of the ion species ", Journal of Applied Physics 99, 093507 (2006).
[2] Z.Q.CHEN ET AL., " Interaction of nitrogen with vacancy defects in N+-implanted ZnO studied using a slow positron beam ", Applied Physics Letters,87, 091910 (2005).
[3] Q.X. ZHAO ET AL., " Deep-level emissions influenced by O and Zn implantations in ZnO ", Applied Physics Letters 87, 211912 (2005).
[4] K.P. VIJAYAKUMAR et AL., " Effects of oxygen ion implantation in spray-pyrolyzed ZnO thin films ", Phys.Stat.Sol.(a) 203, No.5, 860-867 (2006).
[5] JP-A-2005 347 525.

## Revendications

1. Procédé de préparation de ZnO dopé de type p ou de ZnMgO dopé de type p, dans lequel on réalise les étapes successives suivantes :
a) implantation d'ions oxygène O+ dans un ZnO dopé de type n ou un ZnMgO dopé de type n ;
b) premier recuit à une température inférieure ou égale à 1200°C sous oxygène pendant une durée supérieure ou égale à 5 minutes ;
c) implantation d'au moins un ion d'un élément choisi parmi les éléments du groupe I ou les éléments du groupe V du tableau périodique ;
d) second recuit.

2. Procédé selon la revendication 1 dans lequel l'implantation d'ions oxygène est réalisée à température ambiante avec une énergie ou plusieurs énergies de 100 keV à 300 keV, de préférence de 300 keV, et avec une dose totale minimale de 10¹⁵ cm⁻² pour l'implantation des ions oxygène.

3. Procédé selon l'une quelconque des revendications précédentes dans lequel le premier recuit est réalisé à une température de 1000°C à 1200°C pendant une durée au moins égale à 5 minutes.

4. Procédé selon l'une quelconque des revendications précédentes dans lequel dans l'étape c) on réalise l'implantation d'un ion N, ou P ou Li.

5. Procédé selon l'une quelconque des revendications précédentes dans lequel l'implantation de l'étape c) est réalisée à température ambiante avec une énergie de 200 keV à 300 keV, de préférence de 250 keV, et avec une dose totale minimale de 10¹⁵ cm⁻² pour l'implantation des ions.

6. Procédé selon l'une quelconque des revendications précédentes dans lequel le second recuit est réalisé à une température de 200°C à 1000°C, de préférence de 400°C à 800°C pendant une durée d'au moins une minute, de préférence de 1 à 60 minutes.

7. Procédé selon la revendication 6 dans lequel le second recuit est réalisé sous azote, ou sous oxygène, ou sous un mélange d'oxygène et d'azote.

8. Procédé selon l'une quelconque des revendications précédentes dans lequel le ZnO ou le ZnMgO dopé de type n se présente sous la forme d'un substrat et une couche de surface du substrat est transformée respectivement en ZnO ou en ZnMgO dopé de type p.

9. Procédé selon l'une quelconque des revendications 1 à 7 dans lequel le ZnO ou le ZnMgO dopé de type n se présente sous la forme de nanofils.

## Claims

1. Method of preparing p-type doped ZnO or p-type doped ZnMgO, in which the following successive steps are carried out:
a) implantation of O+ oxygen ions in an n-type doped ZnO or an n-type doped ZnMgO;
b) first annealing at a temperature less than or equal to 1200°C under oxygen for a time greater than or equal to 5 minutes;
c) implantation of at least one ion of an element chosen among the elements of group I or the elements of group V of the periodic table;
d) second annealing.

2. Method according to claim 1 in which the implantation of oxygen ions is carried out at ambient temperature with one energy or several energies from 100 keV to 300 keV, preferably 300 keV, and with a minimum total dose of 10¹⁵ cm⁻² for the implantation of the oxygen ions.

3. Method according to any one of the preceding claims in which the first annealing is carried out at a temperature from 1000°C to 1200°C for a time at least equal to 5 minutes.

4. Method according to any one of the preceding claims in which in step c) the implantation of an N, or P or Li ion is carried out.

5. Method according to any one of the preceding claims in which the implantation of step c) is carried out at ambient temperature with an energy from 200 keV to 300 keV, preferably 250 keV, and with a minimum total dose of 10¹⁵ cm⁻² for the implantation of the ions.

6. Method according to any one of the preceding claims in which the second annealing is carried out at a temperature from 200°C to 1000°C, preferably from 400°C to 800°C for a time of at least one minute, preferably from 1 to 60 minutes.

7. Method according to claim 6 in which the second annealing is carried out under nitrogen, or under oxygen, or under a mixture of oxygen and nitrogen.

8. Method according to any one of the preceding claims in which the n-type doped ZnO or ZnMgO is in the form of a substrate and a surface layer of the substrate is transformed respectively into p-type doped ZnO or ZnMgO.

9. Method according to any one of claims 1 to 7 in which the n-type doped ZnO or ZnMgO is in the form of nanowires.

## Patentansprüche

1. Herstellungsverfahren von p-dotiertem ZnO oder p-dotiertem ZnMgO, bei dem man die folgenden sukzessiven Schritte durchführt:
a) Implantieren von O⁺-Sauerstoffionen in ein n-dotiertes ZnO oder ein n-dotiertes ZnMgO;
b) erstes Tempern bei einer Temperatur unter oder gleich 1200°C unter Sauerstoff während eine Dauer von mehr als oder gleich 5 Minuten;
c) Implantieren von wenigstens einem Ion, ausgewählt unter den Elementen der Gruppe I oder den Elementen der Gruppe V des Periodensystems der Elemente;
d) zweites Tempern.

2. Verfahren nach Anspruch 1, bei dem die Sauerstoffionimplantation bei Umgebungstemperatur mit einer Energie oder mehreren Energien von 100 keV bis 300 keV, vorzugsweise 300 keV, und mit einer minimalen Gesamtdosis von 10¹⁵ cm⁻² für die Implantation der Sauerstoffionen durchgeführt wird.

3. Verfahren nach einem der vorhergehenden Ansprüche, bei dem das erste Tempern bei einer Temperatur von 1000°C bis 1200°C während einer Dauer von wenigstens 5 Minuten durchgeführt wird.

4. Verfahren nach einem der vorhergehenden Ansprüche, bei dem man in Schritt c) die Implantation eines N- oder P- oder Li-Ions realisiert.

5. Verfahren nach einem der vorhergehenden Ansprüche, bei dem die Implantation in Schritt c) bei Umgebungstemperatur mit einer Energie von 200 keV bis 300 keV, vorzugsweise 250 keV, und mit einer minimalen Gesamtdosis von 10¹⁵ cm⁻² für die Implantation der Ionen durchgeführt wird.

6. Verfahren nach einem der vorhergehenden Ansprüche, bei dem das zweite Tempern bei einer Temperatur von 200°C bis 1000°C, vorzugsweise 400°C bis 800°C, während einer Dauer von wenigstens einer Minute, vorzugsweise von 1 bis 60 Minuten, durchgeführt wird.

7. Verfahren nach Anspruch 6, bei dem das zweite Tempern unter Stickstoff oder unter Sauerstoff oder unter einem Sauerstoff- und Stickstoffgemisch durchgeführt wird.

8. Verfahren nach einem der vorhergehenden Ansprüche, bei dem das n-dotierte ZnO oder ZnMgO, sich in Form eines Substrats präsentiert, und eine Oberflächenschicht des Substrats, jeweils in p-dotiertes ZnO oder ZnMgO umgewandelt wird.

9. Verfahren nach einem der Ansprüche 1 bis 7, bei dem das n-dotierte ZnO oder ZnMgO sich in Form von Nanofasern präsentiert.
